# EUROPEAN PATENT APPLICATION

(11) **EP 2 246 907 A1**
(43) Date of publication of application: **03.11.2010**
(21) Application number: 10161315.6
(22) Date of filing: 28.04.2010
(51) Int. Cl.: H01L 31/18, H01L 31/048, H01L 31/0216

(54) **Method for providing high-efficiency photovoltaic panels**

(30) Priority: 28.04.2009 IT MO20090102
(71) Applicant: Solution e Partners S.r.l., 35042 Este (PD) (IT)
(72) Inventor: Capuzzi, Emidio, 35043, Monselice PD (IT); Pieragostini, Enrico, 37121, Verona (IT); Patorno, Luciano, 41121, Modena (IT); Sighinolfi, Sergio, 41124, Modena (IT)
(74) Representative: Modiano, Micaela Nadia

(57) **Abstract**

A method for providing high-efficiency photovoltaic panels, comprising:
- a step for providing at least one substantially plate-like photovoltaic panel, which comprises a plurality of photovoltaic cells which are mutually connected electrically, each cell comprising a semiconductor that is treated chemically with pre-doping elements in order to form respective n and p layers that can be affected by sunlight, respectively, directly and by diffusion;
- a first doping step, in which one or more of the photovoltaic cells is treated chemically, at the corresponding n layers, by adding at least one first doping element comprised between Groups 13 and 16 and rows 2 and 5 of the periodic table of the elements;
- a step for first coating of the photovoltaic cells, on the side of the corresponding n layers, with a first mixture, which comprises a polymeric material at a concentration of 5% to 96% by weight on the weight of the first mixture, one or more chemical elements comprised between Groups 11 and 16 of the periodic table of the elements in a quantity from 0.01% to 9.5% by weight on the weight of the first mixture, and enough water to reach 100% by weight on the weight of the first mixture;
- a step for first solidification of the first mixture so as to obtain a first layer of a substantially transparent polymeric material that coats the photovoltaic cells on the side of the corresponding n layers;

comprising:
- a second doping step, in which the photovoltaic cells are treated chemically, at the respective p layers, by adding at least one second doping element comprised between Groups 14 and 17 and rows 3 and 6 of the periodic table of the elements;
- a step for second coating of the photovoltaic cells, on the side of the corresponding p layers, with a second mixture that comprises the same elements as the first mixture but with a different composition by weight; the second doping and the second coating being such as to allow collection of sunlight even on the side of the second face of the panel;
- a step for second solidification of the second mixture so as to obtain a second layer of a substantially transparent polymeric material; the composition by weight of the second mixture being such that the second layer is substantially opaque to diffuse sunlight.

## Description

### METHOD FOR PROVIDING HIGH-EFFICIENCY PHOTOVOLTAIC PANELS

The present invention relates to a method for providing high-efficiency photovoltaic panels.

As is known to the person skilled in the art, photovoltaic panels, used for converting solar energy into electric power, are constituted by a plurality of photovoltaic cells which are mutually connected electrically.

Each one of these photovoltaic cells is constituted in turn by a semiconductor, generally silicon, conveniently doped, generally with boron and phosphorus, so as to obtain a p layer (characterized by an excess of holes and thus of positive charges) and an n layer (characterized by an excess of electrons and thus of negative charges).

An accumulation of charges of opposite sign, and thus an electric field, is created which straddles the p-n junction region that separates such two layers.

The incidence of sunlight on the photovoltaic cells, particularly on their n layer, causes a displacement of electrons and of holes in opposite directions and thus the circulation of electrical current.

Generally, known photovoltaic cells use only the sunlight that strikes directly their n layer, since they are arranged mutually laterally adjacent so that one face (which corresponds to the respective n layer) is directed toward the sun, and therefore is struck directly by the rays of the sun, and one face (which corresponds to the respective p layer) instead is not reached in a direct manner by the rays of the sun.

Currently, photovoltaic cells use only the solar energy that strikes the respective n layers.

Moreover, the power emitted by each individual photovoltaic cell varies through the day, because the intensity and the wavelength of the incident light varies.

In order to improve the sunlight collection time and the power that can be obtained from photovoltaic cells, such cells are treated with two methods disclosed in Italian patent applications RM2003A000147 and VR2007A000148.

Moreover, in order to reduce the Joule effect that occurs due to the microscopic potential differences that are present on the surface of the cells, one or more tracks for the flow of current are formed on such cells and one or more current conveyors converge thereon.

It may occur that in order to better utilize the dimensions and the voltage of the cells, such cells are cut into several subcells, each comprising a portion of the tracks and of the conveyors mentioned above.

Generally, moreover, photovoltaic panels are mutually arranged in series or in parallel, and are connected electrically to a single inverter that is adapted to transform the direct current emitted by the individual panels into alternating current available for feeding to the ordinary electric grid.

Since, as mentioned above, the operating conditions of each individual cell change through the day in mutually different ways, the voltage at which the individual cells emit the maximum power (which can be found by means of the V/I characteristic curve known to the person skilled in the art) varies continuously during the day.

The known inverters that are used are characterized by a function, known as MPPT (Maximum Power Point Tracker), that allows the inverter itself to seek continuously the best point of operation by means of continuous retroactive operating voltage variations.

These known photovoltaic cells are not free from drawbacks, among which one must include the fact that they allow to utilize only the solar energy that strikes directly their n layer.

Known photovoltaic cells, therefore, have a limited efficiency.

Moreover, the subcells that derive from the fragmentation of known photovoltaic cells have an even lower efficiency than such cells, because the arrangement of the portions of the tracks and of the current conveyors is not adapted to the shape of the corresponding subcells and thus does not allow to reduce sufficiently the Joule effect on them.

Even known photovoltaic panel assemblies are not free from drawbacks, among which it is necessary to include the fact that the inverter associated with them does not allow to utilize at its best the maximum power made available by the individual cells in the various periods of the day.

In fact, the inverter, although provided with the MPPT function described previously, has to use such a working voltage as to optimize the operation of the entire assembly of all panels to which is connected.

This working voltage, which certainly does not correspond to the optimum one for at least some of the photovoltaic panels, is defined in practice by an average of the optimum voltages for each individual panel.

Another drawback of known photovoltaic panel assemblies resides in that the surface of each panel that is available to receive sunlight is generally limited by the presence of external bodies that rest on such panels.

The aim of the present invention is to eliminate the drawbacks cited above of the background art, by devising a method for providing photovoltaic cells that allows to increase the efficiency of the cells thus obtained with respect to known ones, using also the solar energy that strikes by diffusion the p layer of said cells.

Within this aim, an object of the present invention is to provide high-efficiency photovoltaic panels.

Another object of the present invention is to provide a method for segmenting the photovoltaic cells in order to improve the efficiency of the single subcells obtained from the segmentation.

Another object of the present invention is to provide a unit for converting solar energy that allows to optimize the maximum power available for each photovoltaic panel in any condition of radiation.

Another object of the present invention is to devise a method for providing photovoltaic panels that allows to keep the external surface of the photovoltaic panels that is directed toward the rays of the sun always free from external bodies and thus available to absorb the corresponding solar energy.

Another object of the present invention is to provide a method that is simple, relatively easy to provide in practice, safe in use, effective in operation, and of relatively low cost.

This aim and these and other objects that will become better apparent hereinafter are achieved by the present method for providing high-efficiency photovoltaic panels, comprising:
- a step for providing at least one substantially plate-like photovoltaic panel, which comprises a plurality of photovoltaic cells which are mutually connected electrically, each cell comprising a semiconductor that is treated chemically with pre-doping elements in order to form respective n and p layers that can be affected by sunlight, respectively, directly and by diffusion;
- a first doping step, in which one or more of said photovoltaic cells is treated chemically, at the corresponding n layers, by adding at least one first doping element comprised between Groups 13 and 16 and rows 2 and 5 of the periodic table of the elements;
- a step for first coating of said photovoltaic cells, on the side of the respective n layers, with a first mixture, which comprises a polymeric material at a concentration of 5% to 96% by weight on the weight of said first mixture, one or more chemical elements comprised between Groups 11 and 16 of the periodic table of the elements in a quantity from 0.01% to 9.5% by weight on the weight of said first mixture, and enough water to reach 100% by weight on the weight of said first mixture;
- a step for first solidification of said first mixture so as to obtain a first layer of a substantially transparent polymeric material that coats said photovoltaic cells on the side of the respective n layers;
**characterized in that** it comprises:
- a second doping step, in which said photovoltaic cells are treated chemically, at the respective p layers, by adding at least one second doping element comprised between Groups 14 and 17 and rows 3 and 6 of the periodic table of the elements;
- a step for second coating of said photovoltaic cells, on the side of the respective p layers, with a second mixture that comprises the same elements as said first mixture but with a different composition by weight; said second doping and said second coating being such as to allow collection of sunlight even on the side of the second face of said panel;
- a step for second solidification of said second mixture so as to obtain a second layer of a substantially transparent polymeric material; the composition by weight of said second mixture being such that said second layer is substantially opaque to diffuse sunlight.

Further characteristics and advantages of the present invention will become better apparent from the detailed description that follows of a preferred but not exclusive embodiment of a method for providing high-efficiency photovoltaic panels, described hereinafter.

The present invention relates to a method for providing high-efficiency photovoltaic panels.

Such method comprises first of all a step of supplying at least one substantially plate-like photovoltaic panel.

Such photovoltaic panel comprises a plurality of photovoltaic cells, which are mutually connected electrically, each cell comprising a semiconductor that is treated chemically with pre-doping elements in order to form respective n and p layers that can be affected by sunlight respectively directly and by diffusion.

Conveniently, the photovoltaic cells are pre-doped with boron and phosphorus, respectively at the respective n layers and the respective p layers.

The photovoltaic cells are inserted within a containment structure, which forms a first face and a second face of the panel, which are directed respectively toward the n layers and the p layers of the photovoltaic cells.

The method further comprises a first doping step, in which one or more of the photovoltaic cells is treated chemically, at the corresponding n layers, by adding at least one first doping element comprised between Groups 13 and 16 and rows 2 and 5 of the periodic table of the elements.

In one particular embodiment, the first doping is performed by adding to the photovoltaic cells, at the corresponding n layers, a micrometric layer of carbon, by way of an atmospheric pressure burner, for example for 15 seconds and at a temperature comprised between 210 °C and 280 °C.

The first doping is followed by a step for first coating of the photovoltaic cells, on the side of the respective n layers, with a first mixture that comprises a polymeric material at a concentration of 5% to 96% by weight on the weight of the first mixture, one or more chemical elements comprised between Groups 11 and 16 of the periodic table of the elements, preferably between Groups 14 and 16, in a quantity of 0.01% to 9.5% by weight on the weight of the mixture and enough water to reach 100% by weight on the weight of the first mixture.

In a particular embodiment, the first mixture has the following composition: 10% oxygen, 8% carbon and 82% propane.

Following the first coating, a step for first solidification of the first mixture is performed so as to obtain a first layer of a substantially transparent polymeric material that coats the photovoltaic cells on the side of the respective n layers.

According to the invention, the method comprises a second doping step, in which the photovoltaic cells are treated chemically, at the respective p layers, by adding at least one second doping element comprised between Groups 14 and 17 and rows 3 and 6 of the periodic table of the elements.

In one particular embodiment, second doping is performed by adding 62% vinyl groups, 18% carbon (C), 11 % of water (H₂O) and 9% of nitrogen (N₂).

According to the invention, moreover, the method comprises a step for second coating of the photovoltaic cells, on the side of the corresponding p layers, with a second mixture that comprises the same elements as the first mixture but with different composition by weight.

In one particular embodiment, the second mixture has the following composition: 52% vinyl groups, 28% carbon and the remaining part water.

The second doping and the second coating are adapted to allow to collect the sunlight that strikes by diffusion the p layers of the photovoltaic cells that constitute the panel.

According to the invention, the method further comprises a step of second cooling/chemical cross-linking of the second mixture so as to obtain a second layer of a substantially transparent polymeric material that coats the photovoltaic cells on the side of the corresponding p layers.

The composition by weight of the second mixture is such as to make the second layer substantially opaque to diffuse sunlight.

More particularly, the first and second doping comprise a step for heating the photovoltaic cells, which is adapted to increase the interatomic distance of the pre-doping elements and a step for inserting the doping elements; conveniently, the temperature and the pressure of the heating are a function of the interatomic distance of the pre-doping elements and of the atomic radius of the doping elements.

More particularly, for an equal interatomic distance of the pre-doping elements, the greater the atomic radius of the doping elements, the higher the temperature to which heating is performed, since the energy supplied must be such that the oscillation of the atoms of the pre-doping elements produced by their excitation causes the corresponding interatomic distances to be greater than the diameter of the atoms of the doping elements.

Insertion of the doping elements is followed by a step for cooling the photovoltaic cells that is adapted to reduce the excitation of the atoms of the pre-doping elements, returning the corresponding interatomic distances to the standard value so as to block the atoms of the doping elements between the atoms of the pre-doping elements.

If the photovoltaic cells are pre-doped at the corresponding n and p layers respectively with phosphorus and boron and the doping elements are the ones mentioned above, heating is performed at a temperature comprised between a minimum temperature of 110 °C and a maximum temperature of 380 °C.

Advantageously, the heating and the cooling are performed in a time interval comprised respectively between a minimum time of 8 seconds and a maximum time of 22 seconds and between a minimum time of 12 seconds and a maximum cooling time of 32 seconds.

The present invention relates, moreover, to a method for segmenting photovoltaic cells, which, for example, can be performed together with or separately from the above cited method for providing high-efficiency photovoltaic panels.

According to the invention, this method of segmentation comprises a step for supplying at least one photovoltaic cell which has an n layer, which is designed to be struck directly by sunlight, and a p layer, which lies opposite the corresponding n layer.

On at least one between the n layer and the p layer, preferably on both, there is at least one first track for conveying the current and one or more first devices for conveying the current to the first track.

As is known to the person skilled in the art, the first tracks formed on the n or p layers of a photovoltaic cell extend from one side of such cell to the opposite side and are adapted to carry the electrical charges to the external circuit, while the first conveyors, which are adapted to carry the superficial electric charges to the first tracks, are arranged at right angles to such first tracks and branch from the cell ends to the first nearest track.

After the supply of the photovoltaic cell, at least one step for cutting the photovoltaic cell itself is performed in order to obtain several subcells, each one of which comprises, at the respective n and/or p layers, a portion of the first track.

The method according to the invention further comprises at least one step for providing at least one second track for conveying the current at the n and/or p layer that comprises the corresponding portion of the first track.

The arrangement of the second tracks at the n and/or p layers of the respective subcells is defined as a function of the position of the portion of the first track formed on the same subcell, so as to reduce current leakages.

Conveniently, if the subcells obtained by cutting the photovoltaic cell have, on the corresponding n and /or p layers, at least one portion of the first current conveyors, and if they are not distributed in a uniform manner on the surface of the corresponding layer, second current conveyors are provided on the individual subcells, so as to reduce the superficial current leakage on each one of them.

Advantageously, the provision of the second tracks and/or of the second current conveyors is performed by means of silk-screen printing of appropriate precision.

In one particular embodiment, the second tracks provided on the subcells have a substantially curved extension.

Moreover, the second tracks may have a width and thickness that can vary along their extension, for example conveniently sized in terms of dimensions and of material used according to the parameters involved.

The invention thus conceived is susceptible of numerous modifications and variations, all of which are within the scope of the appended claims.

All the details may further be replaced with other technically equivalent elements.

In practice, the materials used, as well as the contingent shapes and dimensions, may be any according to requirements without thereby abandoning the protective scope of the appended claims.

The disclosures in Italian Patent Application No. M02009A000102, from which this application claims priority, are incorporated herein by reference.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A method for providing high-efficiency photovoltaic panels, comprising
- a step for providing at least one substantially plate-like photovoltaic panel, which comprises a plurality of photovoltaic cells which are mutually connected electrically, each cell comprising a semiconductor that is treated chemically with pre-doping elements in order to form respective n and p layers that can be affected by sunlight, respectively, directly and by diffusion;
- a first doping step, in which one or more of said photovoltaic cells is treated chemically, at the corresponding n layers, by adding at least one first doping element comprised between Groups 13 and 16 and rows 2 and 5 of the periodic table of the elements;
- a step for first coating of said photovoltaic cells, on the side of the respective n layers, with a first mixture, which comprises a polymeric material at a concentration of 5% to 96% by weight on the weight of said first mixture, one or more chemical elements comprised between Groups 11 and 16 of the periodic table of the elements in a quantity from 0.01% to 9.5% by weight on the weight of said first mixture, and enough water to reach 100% by weight on the weight of said first mixture;
- a step for first solidification of said first mixture so as to obtain a first layer of a substantially transparent polymeric material that coats said photovoltaic cells on the side of the respective n layers;
**characterized in that** it comprises:
- a second doping step, in which said photovoltaic cells are treated chemically, at the respective p layers, by adding at least one second doping element comprised between Groups 14 and 17 and rows 3 and 6 of the periodic table of the elements;
- a step for second coating of said photovoltaic cells, on the side of the respective p layers, with a second mixture that comprises the same elements as said first mixture but with a different composition by weight; said second doping and said second coating being such as to allow collection of sunlight even on the side of the second face of said panel;
- a step for second solidification of said second mixture so as to obtain a second layer of a substantially transparent polymeric material; the composition by weight of said second mixture being such that said second layer is substantially opaque to diffuse sunlight.

2. The method according to claim 1, **characterized in that** said first doping is performed by adding to the photovoltaic cells, at the corresponding n layers, a micrometric layer of carbon, **in that** said first mixture comprises substantially 10% oxygen, 8% carbon and 82% propane and **in that** said second doping is performed by adding 62% vinyl groups, 18% carbon (C), 11 % water (H₂O) and 9% nitrogen (N₂).

3. The method according to one or more of the preceding claims, **characterized in that** said first and second doping comprise:
- a step for heating said photovoltaic cells, which is adapted to increase the interatomic distance of said pre-doping elements;
- a step for inserting said doping elements; the temperature and the pressure of said heating being a function of the interatomic distance of said pre-doping elements and of the atomic radius of said doping elements;
- a step for cooling said photovoltaic cells in order to block said doping elements between the atoms of said pre-doping elements.

4. The method according to claim 3, **characterized in that** said heating step is performed in an interval comprised between a minimum time of 8 seconds and a maximum time of 22 seconds and **in that** said cooling step is performed in an interval comprised between a minimum time of 12 seconds and a maximum cooling time of 32 seconds.

5. A method for segmenting photovoltaic cells, **characterized in that** it comprises:
- a step for supplying at least one photovoltaic cell provided with an n layer, which is adapted to be struck directly by sunlight, and a p layer that lies opposite said n layer; on at least one between said n layer and said p layer there being at least one first track for conveying the current and one or more first conveyors for conveying the current to said first track;
- at least one step for cutting said cell in order to obtain several subcells, each of which comprises, at the corresponding n and/or p layers, a portion of said first track;
- at least one step for providing at least one second track at the n and/or p layer of at least one of said subcells.

6. The method according to claim 5, **characterized in that** the arrangement of said second tracks on said subcells, at the respective n and/or p layers, is defined as a function of the position of said portion of the first track provided on the respective subcell, so as to reduce current leakages.

7. The method according to claim 5 or 6, **characterized in that** said provision is performed by silk-screen printing.

8. The method according to one or more of claims 5 to 7, **characterized in that** said second tracks have a substantially curvilinear extension.

9. The method according to one or more of claims 5 to 8, **characterized in that** said second tracks have a width and/or thickness that can vary along their extension.

10. The method according to one or more of claims 1 to 4, **characterized in that** it comprises at least one step for segmenting said cells by means of a segmentation method according to one or more of claims 5 to 9.
